# EUROPEAN PATENT APPLICATION

(11) **EP 2 453 163 A1**
(43) Date of publication of application: **16.05.2012**
(21) Application number: 10796948.7
(22) Date of filing: 17.03.2010
(51) Int. Cl.: F21S 2/00, F21V 5/04, G02F 1/13357, H01L 33/58, F21Y 101/02

(54) **ILLUMINATION DEVICE, DISPLAY DEVICE, AND TELEVISION RECEIVER**

(30) Priority: 06.07.2009 JP 2009159397
(71) Applicant: Sharp Kabushiki Kaisha, Osaka-shi, Osaka 545-8522 (JP)
(72) Inventor: KASAI, Nobuhiro, Osaka-shi, Osaka 545-8522 (JP)
(74) Representative: Müller-Boré & Partner Patentanwälte
(86) International application number: PCT/JP2010/054515
(87) International publication number: WO 2011/004637

(57) **Abstract**

A backlight unit (49) of a display device (69) including a liquid crystal display panel (59) includes a chassis (41), a diffusion plate (43) which is supported by the chassis, and a point light source for irradiating the diffusion plate with light. The point light source includes an LED (22) mounted on a mounting substrate (21) . A plurality of the LEDs are provided and respectively covered with dif fusion lenses (24). Optical axes (OA) of the diffusion lenses are tilted relative to the diffusion plate, and the diffusion lenses having different tilts of the optical axes exist on the chassis in a mixed manner. The diffusion lenses having the optical axes which tilt in opposite directions are paired, and the pairs are arranged in a matrix.

## Description

### Technical Field

The present invention relates to an illumination device, a display device including the illumination device, and a television receiver including the display device.

### Background Art

A display device incorporating a display panel which does not emit light itself, e.g. a liquid crystal display panel, is usually combined with an illumination device which illuminates the display panel from behind. As a light source of an illumination device of this kind, various kinds of light sources such as a cold-cathode tube and a light-emitting element are used. Examples of light-emitting elements include a light-emitting diode (hereinafter, referred to as "LED"), organic electroluminescent element, and inorganic electroluminescent element, among which an LED is mainstream at the present time. A light source of an illumination device described in Patent Document 1 is also an LED.

In the illumination device described in Patent Document 1, as illustrated in FIG. 10, LEDs 122 are mounted on a mounting substrate 121, and further, lenses 124 which cover the respective LEDs 122 are attached to the mounting substrate 121. The mounting substrate 121, the LED 122, and the lens 124 form a light emitting module mj. A plurality of light emitting modules mj are arranged in a matrix to form a planar light source.

As is seen in Patent Document 1, a lens is usually combined with a light-emitting element. A lens of this kind is required to be designed so as to reduce the directivity of light emitted by the light-emitting element. An example of such a lens can be seen in Patent Document 2.

In an illumination device of the type described in Patent Document 1, a plurality of point light sources are arranged, while, in an illumination device of the type described in Patent Document 3, a plurality of linear light sources such as cold-cathode tubes are arranged. When an illumination device including a plurality of light sources in this way is combined with a display device, if light from the light sources directly enter the illumination device, unevenness in brightness appears on the screen. Therefore, a diffusion plate for diffusing light is placed between the light source and the display device. The diffusion plate is usually formed as a part of the illumination device as is seen in Patent Document 3.

### Citation List

### Patent Document

Patent Document 1: JP 2008-41546 A
Patent Document 2: JP 2008-147453 A
Patent Document 3: JP 2005-19065 A

### Summary of Invention

### Technical Problem

In forming a planar light source with a plurality of point light sources, when the diffusion performance of a lens combined with a point light source is enhanced, sometimes the amount of light emitted in the direction of the optical axis of the point light source is lowered, and the brightness is lowered. The diffusion characteristics vary depending on the combination or package of the point light source and the lens, and, as a result, unevenness in brightness or unevenness in hue may appear on the diffusion plate.

The present invention has been made in view of the above, and an object of the present invention is therefore to reduce as much as possible unevenness in brightness and unevenness in hue which may appear on a diffusion plate in an illumination device including a point light source covered with a lens and a diffusion plate irradiated with light from the point light source.

### Solution to Problem

According to a preferred embodiment of the present invention, there is provided an illumination device, including: a diffusion plate; and a point light source for irradiating the diffusion plate with light, in which the point light source is a light-emitting element mounted on a mounting substrate, a plurality of the point light sources are provided and each of the point light sources is covered with a lens, and the lenses having different tilts of optical axes exist in a mixed manner.

With this structure, not all the optical axes of light beams emitted from the lenses are orthogonal to the diffusion plate, and light beams having diffusion property in particular directions exist in a mixed manner. As a result, without depending solely on a technique of reducing the directivity of the lenses, the extent of mixture of light beams on the diffusion plate is diversified and color mixture property on the diffusion plate is improved, and unevenness in brightness and unevenness in hue on the diffusion plate are reduced.

According to a preferred embodiment of the present invention, in the illumination device having the above-mentioned structure, the lenses having the optical axes which tilt in opposite directions are paired, and the pairs are arranged in a matrix.

With this structure, a planar light source is formed of a matrix of lens pairs which complement each other in brightness and hue, and thus, unevenness in brightness and unevenness in hue on the diffusion plate are effectively reduced.

According to a preferred embodiment of the present invention, in the illumination device having the above-mentioned structure, a plurality of the lenses are grouped so that a series of the tilts of the optical axes forms a loop, and the groups are arranged in a matrix.

With this structure, a planar light source is formed of a matrix of lens groups which complement each other in brightness and hue, and thus, unevenness in brightness and unevenness in hue on the diffusion plate are effectively reduced.

According to a preferred embodiment of the present invention, in the illumination device having the above-mentioned structure, a plurality of the lenses are grouped so that all the optical axes within the group are directed to one point, and the groups are arranged in a matrix.

With this structure, a planar light source is formed of a matrix of lens groups which complement each other in brightness and hue, and thus, unevenness in brightness and unevenness in hue on the diffusion plate are effectively reduced.

According to a preferred embodiment of the present invention, in the illumination device having the above-mentioned structure, each of the lenses has a light diffusion function.

With this structure, the light diffusion function of the lenses enables satisfying light diffusion.

According to a preferred embodiment of the present invention, in the illumination device having the above-mentioned structure, the light diffusion function is imparted to the lenses by subjecting surfaces thereof on the mounting substrate side to a surface roughening treatment.

With this structure, light diffusion becomes more satisfactory.

According to a preferred embodiment of the present invention, in the illumination device having the above-mentioned structure, the light-emitting element may be an LED.

With this structure, a bright illumination device may be obtained using LEDs having remarkably increased brightness in recent years. Further, the life of the light source may be extended and the power consumption of the light source may be reduced.

According to a preferred embodiment of the present invention, in the illumination device having the above-mentioned structure, the LED is formed by applying a fluorescent material having an emission peak in a yellow range to a blue light emitting chip to gain white light.

According to a preferred embodiment of the present invention, in the illumination device having the above-mentioned structure, the LED is formed by applying fluorescent materials, one of which having an emission peak in a green range, the other having an emission peak in a red range, to a blue light emitting chip to gain white light.

According to a preferred embodiment of the present invention, in the illumination device having the above-mentioned structure, the LED is formed by applying a fluorescent material having an emission peak in a green range to a blue light emitting chip and combining a red light emitting chip therewith to gain white light.

According to a preferred embodiment of the present invention, in the illumination device having the above-mentioned structure, the LED is formed by combining a blue light emitting chip, a green light emitting chip, and a red light emitting chip to gain white light.

Color tone of an LED which emits white light is liable to vary due to, for example, stronger blue. By gaining white light in the manner described in the present invention, the color tone is averaged as a whole, and illuminating light having substantially uniform color tone may be obtained.

According to a preferred embodiment of the present invention, in the illumination device having the above-mentioned structure, the LED is a combination of an ultraviolet light chip and a fluorescent material.

According to a preferred embodiment of the present invention, in the illumination device having the above-mentioned structure, the LED is formed by applying fluorescent materials, one of which having an emission peak in a blue range, another having an emission peak in a green range, and the other having an emission range in a red range, to an ultraviolet light chip to gain white light.

When the light source is an ultraviolet light chip, the color tone is liable to vary. According to the structure of the present invention, the color tone is averaged as a whole, and illuminating light having substantially uniform color tone may be obtained.

According to a preferred embodiment of the present invention, in the illumination device having the above-mentioned structure, a plurality of the point light sources are arranged on the mounting substrate which is in a shape having a longitudinal direction, and the mounting substrate is placed on a chassis.

With this structure, compared with a case in which point light sources are placed on a chassis one by one, the assembling efficiency may be improved.

According to a preferred embodiment of the present invention, in the illumination device having the above-mentioned structure, a plurality of the point light sources are arranged on a straight line parallel to the longitudinal direction of the mounting substrate.

With this structure, the aspect in which the mounting substrate is placed uniquely determines the aspect in which the point light sources are arranged, and thus, the design of arrangement of the point light sources becomes easier.

According to a preferred embodiment of the present invention, in the illumination device having the above-mentioned structure, the plurality of point light sources are arranged on the straight line at regular intervals.

With this structure, the mode in which the point light sources are arranged is not changed by the mounting substrate, and thus, the mounting substrate may be used even if the size of the illumination device is changed.

According to a preferred embodiment of the present invention, in the illumination device having the above-mentioned structure, a plurality of the mounting substrates are placed on the chassis, and adjacent mounting substrates among the plurality of the mounting substrates are connected to each other with a connector.

With this structure, if a plurality of kinds of mounting substrates of different sizes are prepared, even when illumination devices of different sizes are formed, by changing the kinds of the mounting substrates to be combined and connecting the mounting substrates to each other with a connector, adaptationmaybe performed easily. Therefore, it is not necessary to design a dedicated mounting substrate for each size of the illumination device, contributing to cost reduction.

According to a preferred embodiment of the present invention, in the illumination device having the above-mentioned structure, mounting substrates which align in the longitudinal direction among the plurality of the mounting substrates are the adjacent mounting substrates.

With this structure, by preparing a plurality of kinds of mounting substrates of different lengths, in other words, having different numbers of the point light sources arranged thereon, even when illumination devices of different sizes are formed, by changing the kinds of the mounting substrates to be combined and connecting the mounting substrates to each other with a connector, adaptation may be performed easily. Therefore, it is not necessary to design a dedicated mounting substrate for each size of the illumination device, which contributes to cost reduction.

According to a preferred embodiment of the present invention, in the illumination device having the above-mentioned structure, the connector includes a combination of a connector half attached to one of the adjacent mounting substrates and a connector half attached to another one of the adjacent mounting substrates, and at least one of the connector halves protrudes outside an end of the mounting substrate to which the one of the connector halves is attached.

With this structure, when mounting substrates which are adjacent to each other are connected to each other with a connector, at least one of the connector halves protrudes outside an end of the mounting substrate to which the one of the connector halves is attached, and thus, connection between the connector halves may be made easily.

According to a preferred embodiment of the present invention, in the illumination device having the above-mentioned structure, the connector includes an outer surface of a bright color.

With this structure, the optical reflectivity of the connector is enhanced and the connector is less liable to absorb light, and thus, unevenness in brightness on the diffusion plate may be reduced.

According to a preferred embodiment of the present invention, in the illumination device having the above-mentioned structure, a plurality of the point light sources are electrically connected in series.

With this structure, current supplied to each of the point light sources may be caused to be the same, and the amount of light emitted from each of the point light sources may be caused to be uniform, and thus, the uniformity of the brightness on the diffusion plate may be improved.

According to a preferred embodiment of the present invention, a display device includes: the illumination device having the above-mentioned structure; and a display panel that receives light from the illumination device.

With this structure, a display device with reduced unevenness in brightness and reduced unevenness in hue may be obtained.

According to the preferred embodiment of the present invention, in the display device having the above-mentioned structure, the display panel includes a liquid crystal display panel.

With this structure, a display device with reduced unevenness in brightness and reduced unevenness in hue may be obtained.

According to a preferred embodiment of the present invention, a television receiver including the display device having the above-mentioned structure is formed.

With this structure, a television receiver with reduced unevenness in brightness and reduced unevenness in hue on a screen thereof may be obtained.

### Advantageous Effects of Invention

According to the present invention, by tilting on purpose the optical axes of the lenses and causing lenses having different tilts of the optical axes to exist in a mixed manner, the extent of mixture of light beams on the diffusion plate may be diversified, the color mixture property on the diffusion plate may be improved, and unevenness in brightness and unevenness in hue on the diffusion plate may be reduced.

### Brief Description of Drawings

[FIG. 1] An exploded perspective view of a display device including an illumination device according to preferred embodiments of the present invention.
[FIG. 2] A partial sectional view of the illumination device according to a first embodiment of the present invention.
[FIG. 3] A partial plan view of the illumination device illustrated in FIG. 2.
[FIGS. 4] Plan views of a diffusion lens of various modes.
[FIGS. 5] Plan views of a diffusion lens of various modes.
[FIG. 6] A partial sectional view of the illumination device according to a second embodiment of the present invention.
[FIG. 7] A plan view of a diffusion lens group forming the illumination device according to a third embodiment of the present invention.
[FIG. 8] A plan view of a diffusion lens group forming the illumination device according to a fourth embodiment of the present invention.
[FIG. 9] An exploded perspective view of a television receiver.
[FIG. 10] An exploded perspective view of a conventional illumination device.
[FIG. 11] A graph illustrating the difference in illuminance depending on the direction of irradiation of LEDs.
[FIG. 12] A view illustrating images of collective brightness of a plurality of LEDs.

### Description of Embodiments

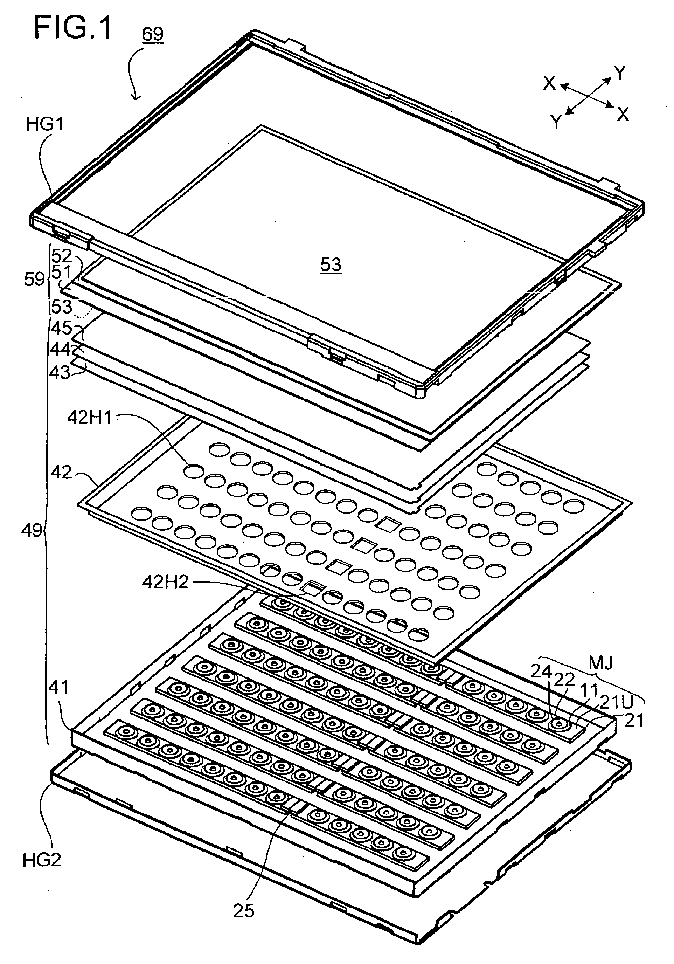

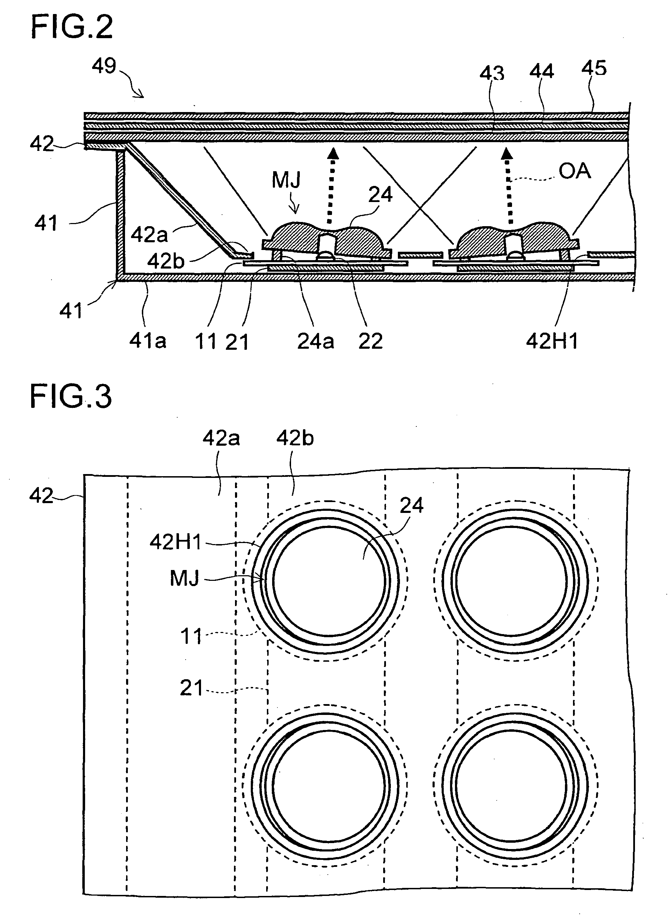

A structure of a display device including an illumination device according to preferred embodiments of the present invention is described referring to FIGS. 1 to 3. In FIG. 1, a display device 69 is illustrated in a state of being placed so as to be horizontal with a display plane thereof being on an upper side.

The display device 69 incorporates a liquid crystal display panel 59 as a display panel thereof. The liquid crystal display panel 59 and a backlight unit 49 for illuminating the liquid crystal display panel 59 from behind are housed in a housing. The housing is formed by assembling a front housing member HG1 and a rear housing member HG2.

The liquid crystal display panel 59 is formed by bonding an active matrix substrate 51 including switching elements such as thin-film transistors (TFTs) and a counter substrate 52 which is opposed to the active matrix substrate 51 with a sealing material (not shown), and filling a space between the active matrix substrate 51 and the counter substrate 52 with liquid crystal.

Polarizing films 53 are respectively stuck to a light receiving surface side of the active matrix substrate 51 and to a light emitting side of the counter substrate 52. The liquid crystal display panel 59 utilizes change in light transmittance due to tilts of liquid crystal molecules to form an image.

The backlight unit 49 which is a specific form of the illumination device according to the present invention has the following structure. Specifically, the backlight unit 49 includes light emitting modules MJ, a chassis 41, a large-sized reflection sheet 42, a diffusion plate 43, a prism sheet 44, and a microlens sheet 45.

The chassis 41 is in the shape of a tray, and upright walls 41b are formed on the periphery of a rectangular main plane 41a.

The light emitting module MJ includes a mounting substrate 21, a point light source placed on the mounting substrate 21, a lens 24 which covers the point light source, and a built-in reflection sheet 11. The point light source includes a light-emitting element mounted on the mounting substrate 21. The light-emitting element according to this embodiment is an LED 22.

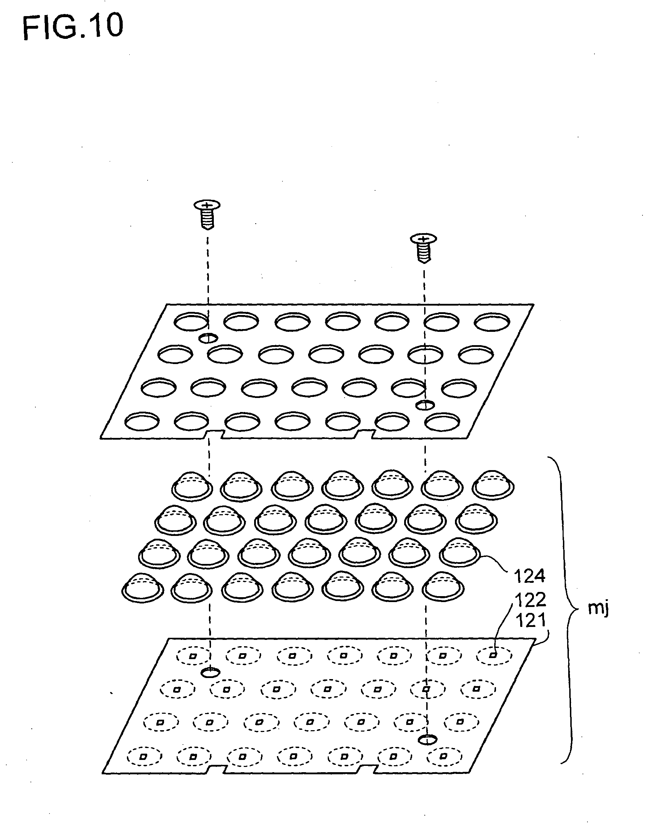

The lens 24 has a light diffusion function. Here, meaning of the light diffusion function of the lens 24 is described. For example, in the case of the illumination device described in Patent Document 1, in the illumination device illustrated in FIG. 10, the lenses 124 are respectively combined with the LEDs 122, but the spread of light from the respective LEDs 122 is small. Therefore, for the purpose of eliminating unevenness in brightness, it is necessary to arrange a large number of light emitting modules mj with high density. Therefore, the component cost and the cost for mounting increase, which causes the illumination device to be expensive as a whole.

The brightness of an LED becomes higher and higher in recent times, and a relatively small number of LEDs can supply light for the whole screen. However, arranging high brightness LEDs sparsely inevitably results in unevenness in brightness, and thus, it is preferred that the LEDs be used in combination with lenses respectively having the light diffusion function. A lens having the light diffusion function is herein referred to as a "diffusion lens".

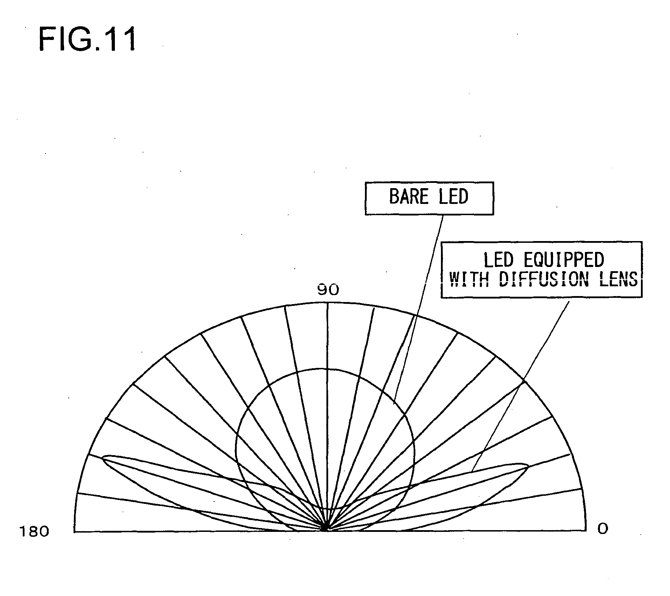

FIG. 11 is a graph illustrating the difference in illuminance (in lux) depending on the direction of irradiation with regard to a bare LED and an LED with a diffusion lens. In the case of a bare LED, the illuminance has a peak at 90°, which is the angle of the optical axis, and drastically decreases away from the angle. On the other hand, in the case of an LED with a diffusion lens, a region in which illuminance at a predetermined level or higher may be enlarged and a peak of the illuminance may be set to be at an angle which is different from that of the optical axis. Note that, needless to say, the illustrated pattern of the illuminance may be changed in any way depending on the design of the diffusion lens.

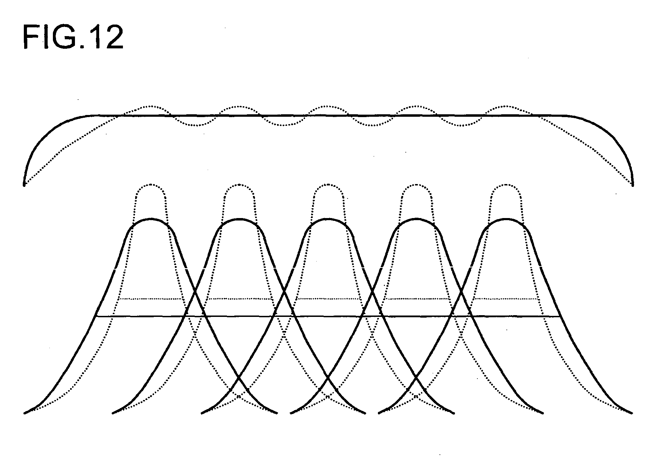

FIG. 12 illustrates images of collective brightness of a plurality of LEDs. In the figure, waveforms in solid lines illustrate the brightness of LEDs with diffusion lenses while waveforms in dotted lines illustrate the brightness of bare LEDs. Horizontal lines in the waveforms indicate widths of the waveforms, respectively, when the brightness is half the peak value (full width at half maximum). In the case of the LEDs with diffusion lenses, each waveform may be caused to have a large width, and thus, it is easy to cause the collective brightness as a whole to be in a flat shape as illustrated in the solid line in an upper portion of the figure. On the other hand, in the case of the bare LEDs, each waveform has a large height and a small width, and it is inevitable that the collective brightness has unevenness. An image having unevenness in brightness in this way is undesirable, and thus, it is almost inevitable to adopt LEDs with diffusion lenses.

In view of the above-mentioned point, the light emitting module MJ is adapted to include the diffusion lens 24.

Surfaces of the diffusion lenses 24 which face the mounting substrates 21 may undergo a surface roughening treatment such as graining to be caused to have the light diffusion function. This enables diffusion of light more satisfactory.

The mounting substrates 21 are prolonged rectangles. A mounting surface 21U which is an upper surface of each mounting substrate 21 has a plurality of electrodes (not shown) formed thereon at predetermined intervals on a straight line parallel to a longitudinal direction of the mounting substrate 21, and the LEDs 22 are mounted on the electrode. The mounting substrate 21 is a substrate common to the plurality of LEDs 22. More specifically, the plurality of LEDs 22 are arranged at predetermined intervals, in this case, at predetermined regular intervals, on a straight line parallel to the longitudinal direction of the mounting substrate 21 as illustrated in FIG. 1.

The plurality of LEDs 22 are arranged on the mounting substrate 21 which is in a shape having the longitudinal direction and the mounting substrates 21 are placed on the chassis 41, and thus, compared with a case where the LEDs 22 are placed on the chassis 41 one by one, the assembling efficiency may be improved. Further, the plurality of LEDs 22 are arranged on the straight line parallel to the longitudinal direction of the mounting substrate 21, and thus, the mode in which the mounting substrates 21 are placed uniquely determines the mode in which the LEDs 22 are placed. Therefore, the design of arrangement of the LEDs 22 becomes easier. The plurality of LEDs 22 are arranged at regular intervals on the straight line, and thus, the mode in which the LEDs 22 are arranged is not changed by the mounting substrate 21. Therefore, the mounting substrates 21 may be used even if the size of the backlight unit 49 is changed.

Each of the diffusion lenses 24 is circular in plan view, has a plurality of legs 24a on a lower surface thereof, and is attached to the mounting substrate 21 by adhering tips of the legs 24a to the mounting surface 21U of the mounting substrate 21 with an adhesive. The existence of the legs 24a creates a gap between the mounting substrate 21 and the diffusion lens 24. Airflow which passes through the gap cools the LED 22. Note that, insofar as the problem of heat dissipation may be solved, an integrally molded light emitting module having an LED built-in in a diffusion lens may also be used.

Various types of LEDs may be used as the LEDs 22. For example, an LED which is formed by applying a fluorescent material having an emission peak in a yellow range to a blue light emitting chip to gain white light may be used. An LED which is formed by applying fluorescent materials, one of which having an emission peak in a green range, the other having an emission peak in a red range, to a blue light emitting chip to gain white light may also be used. An LED which is formed by applying a fluorescent material having a light emission peak in a green range to a blue light emitting chip and combining a red light emitting chip therewith to gain white light may also be used. An LED which is formed by combining a blue light emitting chip, a green light emitting chip, and a red light emitting chip to gain white light may also be used.

Color tone of an LED which emits white light is liable to vary due to, for example, stronger blue. By gaining white light in the manner described above, the color tone is averaged as a whole, and illuminating light having substantially uniform color tone may be obtained.

As LED of another type, one formed by combining an ultraviolet light chip with a fluorescent material, in particular, one formed by applying a fluorescent materials, one of which having an emission peak in a blue range, another having an emission peak in a green range, and the other having an emission range in a red range, to an ultraviolet light chip to gain white light may also be used.

When the light source is an ultraviolet light chip, the color tone is liable to vary. According to the structure described above, the color tone is averaged as a whole, and illuminating light having substantially uniform color tone may be obtained.

In FIG. 1, a mounting substrate 21 having five LEDs 22 arranged thereon at regular intervals on a straight line parallel to the longitudinal direction and a mounting substrate 21 having eight LEDs 22 arranged thereon at regular intervals on a straight line parallel to the longitudinal direction are arranged side by side so as to be aligned in the longitudinal direction and are connected to each other with a connector 25. The connector 25 includes a plug connector half and a socket connector half. The connector halves are attached to an end of the mounting substrate 21 having the five LEDs 22 and an end of the mounting substrate 21 having the eight LEDs 22, respectively, the ends facing each other. At least one of the connector halves protrudes from the end of the mounting substrate 21 to which the one of the connector halves is attached. This eases the connection between the connector halves. Note that, in the embodiment illustrated in FIG. 1, both of the connector halves protrude from the ends of the mounting substrates 21, respectively.

A plurality of sets each including the mounting substrate 21 having the five LEDs 22 and the mounting substrate 21 having the eight LEDs 22 connected to each other with the connector 25 are arranged on the chassis 41 so as to be in parallel to one another. The LEDs 22 in the mounting substrate 21 are arranged in the direction of a long side of the chassis 41, that is, in the direction of an arrow X of FIG. 1 . The sets each including the two mounting substrates 21 are arranged in the direction of a short side of the chassis 41, that is, in the direction of an arrow Y of FIG. 1. Therefore, the LEDs 22 are arranged in a matrix. The mounting substrates 21 are fixed to the chassis 41 by appropriate means such as swaging, bonding, screwing, or riveting.

A plurality of mounting substrates 21 are placed on the chassis 41, and the mounting substrates 21 which are side by side are connected to each other with the connector 25, and thus, if a plurality of kinds of the mounting substrates 21 of different sizes are prepared, even when backlight units 49 of different sizes are formed, by changing the kinds of the mounting substrates 21 to be combined and connecting the mounting substrates 21 to each other with the connector 25, adaptation may be performed easily. Therefore, it is not necessary to design a dedicated mounting substrate 21 for each size of the backlight unit 49, contributing to cost reduction. Further, among the mounting substrates 21, ones which are aligned with each other in the longitudinal direction are mounting substrates which are side by side, and thus, by preparing a plurality of kinds of the mounting substrates 21 of different lengths, in other words, having different numbers of the LEDs 22 arranged thereon, when the backlight units 49 of different sizes are formed, adaptation may be performed easily.

The built-in reflection sheet 11 is placed between the mounting substrate 21 and the diffusion lens 24. The built-in reflection sheet 11 is fixed at a position on the mounting surface 21U which faces a lower surface of the diffusion lens 24. The optical reflectivity of the built-in reflection sheet 11 is higher than that of the mounting substrate 21. The built-in reflection sheet 11 is also circular in plan view, and is concentric with the diffusion lens 24. The diameter of the built-in reflection sheet 11 is larger than that of the diffusion lens 24. A through hole for passing each of the legs 24a of the diffusion lens 24 is formed in the built-in reflection sheet 11.

The reflection sheet 42, the shape of which in plan view is similar to that of the chassis 41, is overlaid on the chassis 41. The reflection sheet 42 is a foam resin sheet which is similar to the built-in reflection sheet 11. The outermost portions of edges of the reflection sheet 42 are put on the upright walls 41b of the chassis 41, and portions just inside are tilted surfaces 42a which go downward toward the main plane 41a of the chassis 41. The lowermost portions of the tilted surfaces 42a lead to a main plane 42b of the reflection sheet 42 itself. The main plane 42b overlaps the built-in reflection sheet 11.

Circular pass-through openings 42H1, which are sized so that the diffusion lenses 24 can pass through but the built-in reflection sheets 11 cannot, are formed in the reflection sheet 42 at positions aligning the light emitting modules MJ. Further, rectangular pass-through openings 42H2, through which the connectors 25 protrude, are also formed in the reflection sheet 42 at positions aligning the connectors 25.

The connectors 25 are exposed at the pass-through openings 42H2, and thus, the optical reflectivity of the connectors 25 themselves affects the brightness of the diffusion plate 43. Therefore, the connectors 25 are formed so that portions thereof which are exposed to the outside when the mounting substrates 21 are connected to each other exhibit a bright color. More specifically, the connectors 25 are finished in a bright color such as white, ivory, or bright gray by selecting a material of skin portions thereof or by painting. This enhances the optical reflectivity of the connectors 25 and causes the connectors 25 to be less liable to absorb light, and thus, unevenness in brightness on the diffusion plate 43 may be reduced.

When the LEDs 22 are lighted, light emitted from the LEDs 22 irradiates the diffusion plate 43 from a rear surface thereof. Light which does not directly go toward the diffusion plate 43 is reflected by the reflection sheet 42 or the built-in reflection sheets 11 toward the diffusion plate 43. Light is diffused inside the diffusion plate 43, and thus, from the outside, the diffusion plate 43 appears as a plane the brightness of which is relatively uniform.

The LEDs 22 may be adapted to be electrically connected in series with the pairs of the mounting substrates 21 connected to each other with the connector 25 being a unit, or with all the LEDs 22 being nonhierarchical. This may cause a current supplied to the respective LEDs 22 to be the same and may cause the amount of light emitted from each of the LEDs 22 to be uniform, and thus, the uniformity of the brightness on the diffusion plate 43 may be enhanced.

Each of the diffusion lenses 24 is in the shape of a body of revolution, and the central axis of the body of revolution is an optical axis OA. The optical axis OA is not orthogonal to the diffusion plate 43 but is tilted. The tilts of the optical axes OA are not the same, and the diffusion lenses 24 having different tilts of the optical axes OA are caused to exist in a mixed manner all over the backlight unit 49.

Such a structure causes the optical axes OA to be not limited to ones orthogonal to the diffusion plate 43 and causes light beams having diffusion property in particular directions to exist in a mixed manner. As a result, without depending solely on a technique of reducing the directivity of the diffusion lenses 24, the extent of mixture of light beams on the diffusion plate 43 is diversified, the color mixture property on the diffusion plate 43 is improved, and unevenness in brightness and unevenness in hue on the diffusion plate 43 are reduced.

The diffusion lenses 24 are in pairs in which the tilt of the optical axis OA of one of the diffusion lenses 24 is in a direction opposite to the direction of the optical axis OA of the other, and such pairs are arranged in a matrix. In a first embodiment, one of the diffusion lenses 24 on a mounting substrate 21 and one of the diffusion lenses 24 on an adjacent mounting substrate 21 which are adjacent to each other are combined as a pair.

The diffusion lenses 24 having the optical axes OA, respectively, which tilt in opposite directions, complement each other in brightness and hue. Such pairs of the diffusion lenses 24 are arranged in a matrix to form a planar light source, and thus, unevenness in brightness and unevenness in hue on the diffusion plate 43 may be effectively reduced.

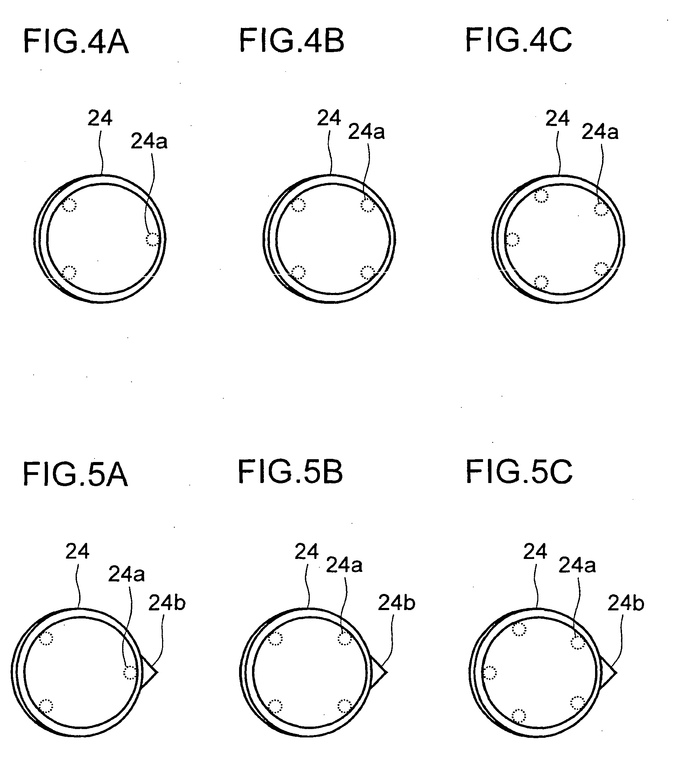

The diffusion lens 24 the optical axis OA of which is tilted may be easily obtained by lengthening some of the plurality of legs 24a and shortening some other. The number of the legs 24a may be three as illustrated in FIG. 4(a), may be four as illustrated in FIG. 4(b), or may be five as illustrated in FIG. 4(c). The number may be other than these. With regard to the lengths of the legs 24a, referring to FIGS. 4, it may be that the legs 24a positioned on a left side with respect to the center of the diffusion lens 24 are lengthened while the legs 24a positioned on a right side are shortened, and the opposite may also be possible.

The diffusion lenses 24 are attached to the mounting substrates 21 using pick-and-place equipment (not shown). Here, it is convenient if the pick-and-place equipment may determine the direction of the diffusion lenses 24 (which side is lower) . There are various techniques to be thought which may cause the pick-and-place equipment to be able to determine the direction of the diffusion lenses 24. FIGS. 5 illustrate examples of the technilues. In FIGS. 5, a protrusion 24b is formed on a side in which the diffusion lens 24 is lowered such that the pick-and-place equipment may determine the direction of the diffusion lens 24 by image recognition. The protrusion 24b may be formed on a side in which the diffusion lens 24 is raised.

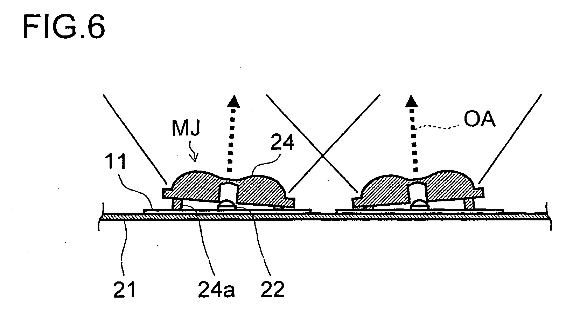

FIG. 6 illustrates the backlight unit 49 according to a second embodiment of the present invention. In the second embodiment, a pair of diffusion lenses 24 having the optical axes OA which tilt in opposite directions is not set between adjacent mounting substrates 21 but is set as adjacent diffusion lenses 24 on the same mounting substrate 21. Effects are the same as those of the first embodiment.

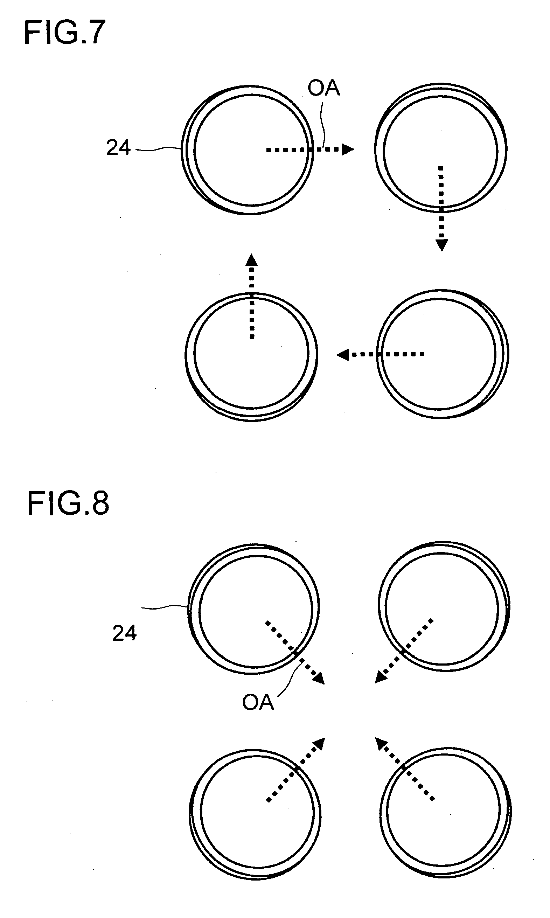

FIG. 7 illustrates the backlight unit 49 according to a third embodiment of the present invention. In the third embodiment, four diffusion lenses 24 arranged in the corners of a square, respectively, form one group. The directions of the tilts of the optical axes OA of the four diffusion lenses 24 differ from one another by 90°. More specifically, in plan view, the series of the tilts of the optical axes OA forms a loop. Such groups of the diffusion lenses 24 are arranged in a matrix.

The four diffusion lenses 24, the directions of the tilts of the optical axes OA of which differ from one another by 90°, complement each other in brightness and hue. Such pairs of the diffusion lenses 24 are arranged in a matrix to form the planar light source, and thus, unevenness in brightness and unevenness in hue on the diffusion plate 43 may be effectively reduced.

FIG. 8 illustrates the backlight 49 according to a fourth embodiment of the present invention. In the fourth embodiment, also, four diffusion lenses 24 arranged in the corners of a square, respectively, form one group. All the four optical axes OA of the four diffusion lenses 24 goes toward one point. The one pint is on a line which rises perpendicularly from a center of the square. Such groups of the diffusion lenses 24 are arranged in a matrix.

In the fourth embodiment, also, the four diffusion lenses 24, the directions of the tilts of the optical axes OA of which differ from one another by 90°, complement each other in brightness and hue. Such pairs of the diffusion lenses 24 are arranged in a matrix to form the planar light source, and thus, unevenness in brightness and unevenness in hue on the diffusion plate 43 may be effectively reduced.

In the third embodiment and the fourth embodiment, the number of the diffusion lenses 24 per group is not limited to four, and may be any number which is equal to or larger than three.

The arrangement of the diffusion lenses 24 in the first to fourth embodiments is not exclusive and may be appropriately combined when being carried out.

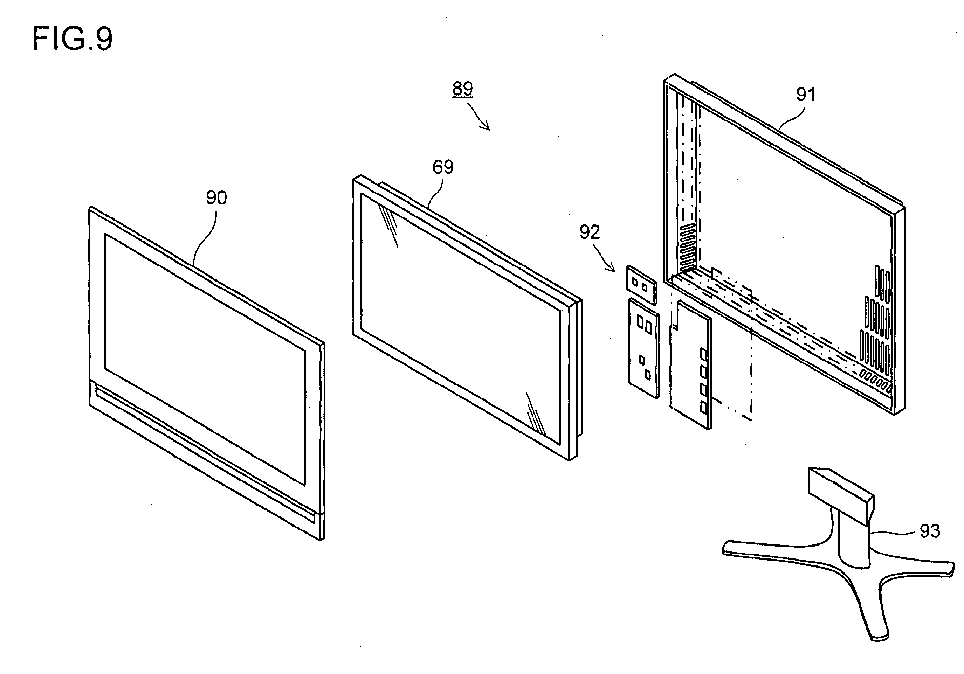

FIG. 9 illustrates an exemplary structure of a television receiver which incorporates the display device 69. A television receiver 89 houses the display device 69 and a control board group 92 in a cabinet which is formed by assembling a front cabinet 90 and a rear cabinet 91. The cabinet is supported by a stand 93.

Hereinabove, the embodiments of the present invention are described, but the present invention is not limited thereto, and various modifications can be made thereto for carrying out the present invention without departing from the gist of the present invention.

### Industrial Applicability

The present invention is widely applicable to illumination devices which irradiate a diffusion plate with light from a light source. Further, the present invention is widely applicable to display devices which include the above-mentioned illumination device and to television receivers which include the above-mentioned display device.

### Reference Signs List

- 49: backlight unit
- 41: chassis
- 43: diffusion plate
- MJ: light emitting module
- 11: built-in reflection sheet
- 21: mounting substrate
- 22: LED
- 24: diffusion lens
- 24a: leg
- 42: reflection sheet
- OA: optical axis
- 59: liquid crystal display panel
- 69: display device
- 89: television receiver

## Claims

1. An illumination device, comprising:
a diffusion plate;
a chassis for supporting the diffusion plate; and
a point light source placed on the chassis for irradiating the diffusion plate with light,
wherein the point light source comprises a light-emitting element mounted on a mounting substrate, a plurality of the point light sources are provided and each of the point light sources is covered with a lens, and the lenses having different tilts of optical axes exist in a mixed manner.

2. An illumination device according to claim 1, wherein the lenses having the optical axes which tilt in opposite directions are paired, and the pairs are arranged in a matrix.

3. An illumination device according to claim 1, wherein a plurality of the lenses are grouped so that a series of the tilts of the optical axes forms a loop, and the groups are arranged in a matrix.

4. An illumination device according to claim 1, wherein a plurality of the lenses are grouped so that all the optical axes within the group are directed to one point, and the groups are arranged in a matrix.

5. An illumination device according to claim 1, wherein each of the lenses has a light diffusion function.

6. An illumination device according to claim 5, wherein the light diffusion function is imparted to the lenses by subjecting surfaces thereof on the mounting substrate side to a surface roughening treatment.

7. An illumination device according to claim 1, wherein the light-emitting element comprises an LED.

8. An illumination device according to claim 7, wherein the LED is formed by applying a fluorescent material having a light emission peak in a yellow range to a blue light emitting chip to gain white light.

9. An illumination device according to claim 7, wherein the LED is formed by applying fluorescent materials, one of which having an emission peak in a green range, the other having an emission peak in a red range, to a blue light emitting chip to gain white light.

10. An illumination device according to claim 7, wherein the LED is formed by applying a fluorescent material having an emission peak in a green range to a blue light emitting chip and combining a red light emitting chip therewith to gain white light.

11. An illumination device according to claim 7, wherein the LED is formed by combining a blue light emitting chip, a green light emitting chip, and a red light emitting chip to gain white light.

12. An illumination device according to claim 7, wherein the LED is a combination of a ultraviolet light chips and a fluorescent material.

13. An illumination device according to claim 12, wherein the LED is formed by applying fluorescent materials, one of which having an emission peak in a blue range, another having an emission peak in a green range, and another having an emission range in a red range, to an ultraviolet light chip to gain white light.

14. An illumination device according to claim 1, wherein the plurality of point light sources are arranged on the mounting substrate which is in a shape having a longitudinal direction, and the mounting substrate is placed on the chassis.

15. An illumination device according to claim 14, wherein a plurality of the point light sources are arranged on a straight line parallel to the longitudinal direction of the mounting substrate.

16. An illumination device according to claim 15, wherein the plurality of point light sources are arranged on the straight line at regular intervals.

17. An illumination device according to claim 14, wherein a plurality of the mounting substrates are placed on the chassis, and adj acent mounting substrates among the plurality of the mounting substrates are connected to each other with a connector.

18. An illumination device according to claim 17, wherein mounting substrates which align in the longitudinal direction among the plurality of the mounting substrates are the adjacent mounting substrates.

19. An illumination device according to claim 17, wherein the connector includes a combination of a connector half attached to one of the adjacent mounting substrates and a connector half attached to another one of the adjacent mounting substrates, and at least one of the connector halves protrudes outside an end of the mounting substrate to which the one of the connector halves is attached.

20. An illumination device according to claim 17, wherein the connector includes an outer surface of a bright color.

21. An illumination device according to claim 1, wherein a plurality of the point light sources are electrically connected in series.

22. A display device, comprising:
the illumination device according to any one of claims 1 to 21; and
a display panel that receives light from the illumination device.

23. A display device according to claim 22, wherein the display panel comprises a liquid crystal display panel.

24. A television receiver, comprising the display device according to claim 22.
